# EUROPEAN PATENT APPLICATION

(11) **EP 3 477 313 A1**
(43) Date of publication of application: **01.05.2019**
(21) Application number: 17814447.3
(22) Date of filing: 13.03.2017
(51) Int. Cl.: G01R 21/133, G01R 22/10

(54) **POWER ANALYSIS METHOD AND DEVICE**

(30) Priority: 22.06.2016 CN 201610471859; 22.06.2016 CN 201620632774 U
(71) Applicant: Guangzhou Zhiyuan Electronics Co., Ltd., Guangzhou, Guangdong 510000 (CN)
(72) Inventor: ZHOU, Ligong, Guangzhou Guangdong 510000 (CN)
(74) Representative: Reitstötter Kinzebach
(86) International application number: PCT/CN2017/076395
(87) International publication number: WO 2017/219708

(57) **Abstract**

A power analysis method and device. The power analysis method comprises: performing wideband sampling on voltage signals and/or current signals to obtain voltage sampling data and/or current sampling data (S101); dividing the voltage sampling data and/or the current sampling data into two paths of data for transmission (S102); in the transmission, performing normal power parameter calculation on the first path of data to obtain the normal power parameter calculation result, and performing fundamental wave decomposition on the second path of data to obtain a fundamental wave component (S103); and calculating a power parameter in a non-sinusoidal imbalanced condition according to the normal power parameter calculation result and the fundamental wave component, so as to obtain a non-sinusoidal unbalanced power parameter calculation result (S104), and to achieve the objective of accurately measuring a power parameter in the non-sinusoidal unbalanced condition.

## Description

### TECHNICAL FIELD

The present application claims priority to Chinese Patent Application No. 201610471859.X, titled "METHOD AND APPARATUS FOR POWER ANALYSIS", filed on June 22, 2016 with the State Intellectual Property Office of the People's Republic of China, which is incorporated herein by reference in its entirety.

The present application claims priority to Chinese Patent Application No. 201620632774.0, titled "APPARATUS FOR POWER ANALYSIS", filed on June 22, 2016 with the State Intellectual Property Office of the People's Republic of China, which is incorporated herein by reference in its entirety.

### BACKGROUND

With continuous development of electronic equipment, non-linear loads such as motor speed control drivers, rectifier equipment, and electric-arc furnaces are widely used in industry and commerce. These loads may cause distortion or unbalance of voltage or current. However, traditional measuring instruments are mostly designed based on 50/60Hz sine wave. It has been proved that there is a large error in case of waveform distortion, and power consumption of users cannot be reflected correctly.

In conventional technology, power is analyzed based on classical power theories. Specifically, a pure analog circuit is utilized for processing or an analog-to-digital conversion circuit is utilized to obtain discrete values, then a processor is utilized to calculate effective values of the voltage and current and active power, then apparent power and a power factor are calculated according to the effective values, and then reactive power is obtained from the numerical triangular relationship among the apparent power, the active power and the reactive power. However, the classical power theory is based on a sinusoidal single-frequency signal and a balanced system, and cannot measure power parameters accurately under a non-sinusoidal unbalanced condition.

Therefore, how to accurately measure the power parameters under the non-sinusoidal unbalanced condition is an urgent problem to be solved by those skilled in the art.

### SUMMARY

In order to address the above technical issues, a method and an apparatus for power analysis are provided according to the present disclosure, so as to achieve accurate measurement of power parameters under a non-sinusoidal unbalanced condition.

To achieve the above objective, following technical solutions are provided in the present disclosure.

A method for power analysis , including:
performing a wide-band sampling on a voltage signal and/or a current signal to obtain voltage sampling data and/or current sampling data;
dividing the voltage sampling data and/or the current sampling data into data of two channels for transmission;
calculating, during the transmission, a normal power parameter for data of a first channel to obtain a normal power parameter calculation result, and performing, during the transmission, fundamental-wave decomposition on data of a second channel to obtain a fundamental-wave component; and
calculating, based on the normal power parameter calculation result and the fundamental-wave component, a power parameter under a non-sinusoidal unbalanced condition, to obtain a non-sinusoidal unbalanced power parameter calculation result;
where the power parameter under the non-sinusoidal unbalanced condition is calculated according to a calculation standard IEEE std 1459 that is established by the Institute of Electrical and Electronics Engineers for power parameters under the non-sinusoidal unbalanced condition.

Preferably, the method further includes:
displaying the normal power parameter calculation result and/or the non-sinusoidal unbalanced power parameter calculation result.

Preferably, the wide-band sampling performed on the voltage signal and/or the current signal is a synchronous sampling, and performing fundamental-wave decomposition on the data of the second channel to obtain the fundamental-wave component includes:
performing a Fourier transform on the data of the second channel to obtain the fundamental-wave component.

Preferably, the wide-band sampling performed on the voltage signal and/or the current signal is an asynchronous sampling, and performing fundamental-wave decomposition on the data of the second channel to obtain the fundamental-wave component includes:
performing a Fourier transform on the data of the second channel to obtain the fundamental-wave component.

Preferably, the wide-band sampling performed on the voltage signal and/or the current signal is an asynchronous sampling, and performing fundamental-wave decomposition on the data of the second channel to obtain the fundamental-wave component includes:
performing a wavelet transform on the data of the second channel to obtain the fundamental-wave component.

An apparatus for power analysis is provided, including a sampling module, a normal power parameter calculation module, a fundamental-wave decomposition module, and a non-sinusoidal unbalanced power parameter calculation module, where:
an output terminal of the sampling module is respectively connected to an input terminal of the normal power parameter calculation module and an input terminal of the fundamental-wave decomposition module, and the sampling module is configured to perform a wide-band sampling on a voltage signal and/or a current signal, and divide voltage sampling data and/or the current sampling data that are obtained into data of two channels, where data of a first channel is sent to the normal power parameter calculation module, and data of a second channel is sent to the fundamental-wave decomposition module;
the input terminal of the normal power parameter calculation module is connected to the output terminal of the sampling module, an output terminal of the normal power parameter calculation module is connected to a first input terminal of the non-sinusoidal unbalanced power parameter calculation module, and the normal power parameter calculation module is configured to calculate a normal power parameter for the data of the first channel to obtain a normal power parameter calculation result, and send the normal power parameter calculation result to the non-sinusoidal unbalanced power parameter calculation module;
the input terminal of the fundamental-wave decomposition module is connected to the output terminal of the sampling module, an output terminal of the fundamental-wave decomposition module is connected to a second input terminal of the non-sinusoidal unbalanced power parameter calculation module, and the fundamental-wave decomposition module is configured to perform fundamental-wave decomposition on the data of the second channel to obtain a fundamental-wave component, and send the fundamental-wave component to the non-sinusoidal unbalanced power parameter calculation module;
the first input terminal of the non-sinusoidal unbalanced power parameter calculation module is connected to the output terminal of the normal power parameter calculation module, the second input terminal of the non-sinusoidal unbalanced power parameter module is connected to the output terminal of the fundamental-wave decomposition module, and the non-sinusoidal unbalanced power parameter calculation module is configured to calculate, based on the fundamental-wave component and the normal power parameter calculation result, a power parameter under a non-sinusoidal unbalanced condition, to obtain a non-sinusoidal unbalanced power parameter calculation result; and
the power parameter under the non-sinusoidal unbalanced condition is calculated according to a calculation standard IEEE std 1459 that is established by the Institute of Electrical and Electronics Engineers for power parameters under the non-sinusoidal unbalanced condition.

Preferably, the apparatus further includes a display module, where:
the display module is connected to the output terminal of the normal power parameter calculation module and an output terminal of the non-sinusoidal unbalanced power parameter calculation module, and is configured to display the normal power parameter calculation result and/or the non-sinusoidal unbalanced power parameter calculation result.

Preferably, the wide-band sampling on the voltage signal and/or the current signal by the sampling module is a synchronous sampling, and the fundamental-wave decomposition module is configured to perform a Fourier transform on the data of the second channel to obtain the fundamental-wave component.

Preferably, the wide-band sampling on the voltage signal and/or the current signal by the sampling module is an asynchronous sampling, and the fundamental-wave decomposition module is configured to perform a Fourier transform on the data of the second channel to obtain the fundamental-wave component;

Preferably, the wide-band sampling on the voltage signal and/or the current signal by the sampling module is an asynchronous sampling, and the fundamental-wave decomposition module is configured to perform a wavelet transform on the data of the second channel to obtain the fundamental-wave component.

As can be seen from the above technical solution, the present disclosure provides the method and the apparatus for power analysis. The method includes: performing the wide-band signal sampling on the voltage signal and/or the current signal to obtain the voltage sampling data and/or the current sampling data; dividing the voltage sampling data and/or the current sampling data into the data of two channels for transmission; calculating, during the transmission, the normal power parameter for the data of the first channel to obtain the normal power parameter calculation result; performing, during the transmission, fundamental-wave decomposition on the data of the second channel to obtain the fundamental-wave component; and calculating, based on the normal power parameter calculation result and the fundamental-wave component, the power parameter under the non-sinusoidal unbalanced condition to obtain the non-sinusoidal unbalanced power parameter calculation result. It can be seen that the present disclosure enables accurate measurement of the power parameter under the non-sinusoidal unbalanced condition.

### BRIEF DESCRIPTION OF THE DRAWINGS

For clearer illustration of the technical solutions according to embodiments of the present disclosure or conventional techniques, hereinafter are briefly described the drawings to be applied in embodiments of the present disclosure or conventional techniques. Apparently, the drawings in the following descriptions are only some embodiments of the present disclosure, and other drawings may be obtained by those skilled in the art based on the provided drawings without creative efforts.
Figure 1 is a flowchart of a method for power analysis according to a first embodiment of the present disclosure;
Figure 2 is a flowchart of a method for power analysis according to a second embodiment of the present disclosure;
Figure 3 is a schematic structural diagram of an apparatus for power analysis according to a third embodiment of the present disclosure; and
Figure 4 is a schematic structural diagram of an apparatus for power analysis according to a fourth embodiment of the present disclosure.

### DETAILED DESCRIPTION OF THE EMBODIMENTS

Hereinafter technical solutions in embodiments of the present disclosure are described clearly and completely in conjunction with the drawings in embodiments of the present closure. Apparently, the described embodiments are only some rather than all of the embodiments of the present disclosure. Any other embodiments obtained based on the embodiments of the present disclosure by those skilled in the art without any creative effort fall within the scope of protection of the present disclosure.

A method and an apparatus for power analysis are provided according to embodiments of the present disclosure, so as to achieve accurate measurement of power parameters under a non-sinusoidal unbalanced condition.

### First Embodiment

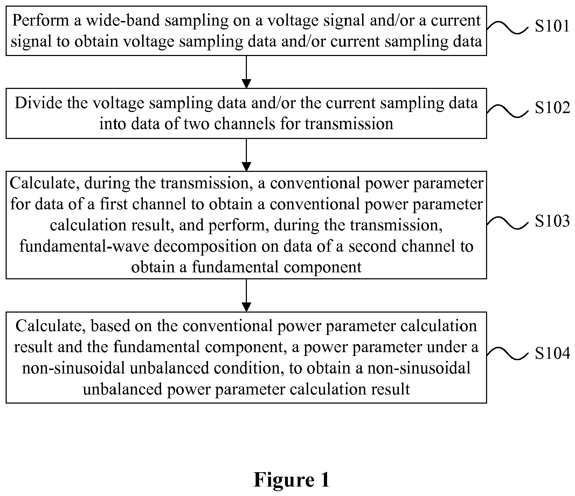

A method for power analysis is provided according to the first embodiment of the present disclosure, as shown in Figure 1, which is a flowchart of a method for power analysis disclosed in a first embodiment of the present disclosure. The method includes steps S101 to S104.

In step S101, a wide-band sampling is performed on a voltage signal and/or a current signal to obtain voltage sampling data and/or current sampling data.

It should be noted that the wide-band sampling on the voltage signal and/or the current signal enables sampling on a wide-band non-sinusoidal signal having a fundamental-wave frequency ranging from 0.1 Hz to 5 kHz.

In step S102, the voltage sampling data and/or the current sampling data is divided into data of two channels for transmission.

It should be noted that in a case that the wide-band sampling is only performed on the voltage signal, the voltage sampling data is obtained, and the voltage sampling data is divided into the data of two channels, where the data of a first channel and the data of a second channel are both voltage sampling data.

In a case that the wide-band sampling is only performed on the current signal, the current sampling data is obtained, and the current sampling data is divided into the data of two channels, where the data of the first channel and the data of the second channel are both current sampling data.

In a case that the wide-band sampling is simultaneously performed on the voltage signal and the current signal, the voltage sampling data and the current sampling data are obtained, and the voltage sampling data and the current sampling data are divided into the data of two channels, where each of the data of the first channel data and the data of the second channel includes voltage sampling data and current sampling data.

In step S103, during the transmission process, a normal power parameter is calculated for the data of the first channel to obtain a normal power parameter calculation result, and fundamental-wave decomposition is performed on the data of the second channel to obtain a fundamental-wave component.

In step S104, a power parameter under a non-sinusoidal unbalanced condition is calculated based on the normal power parameter calculation result and the fundamental-wave component, to obtain a non-sinusoidal unbalanced power parameter calculation result.

The power parameter under the non-sinusoidal unbalanced condition is calculated according to a calculation standard IEEE std 1459, which is established by the Institute of Electrical and Electronics Engineers for power parameters under the non-sinusoidal unbalanced condition.

It should also be noted that calculation of the normal power parameter includes, but is not limited to, calculation of an effective value of voltage, an effective value of current, active power, apparent power, reactive power, and a power factor.

Similarly, calculation of the power parameter under the non-sinusoidal unbalanced condition includes, but is not limited to, calculation of a voltage of a fundamental wave, a current of a fundamental wave, a voltage of a non-fundamental wave, a current of a non-fundamental wave, equivalent apparent power, non-active power, equivalent apparent power of a fundamental wave, equivalent apparent power of a non-fundamental wave, basic sinusoidal apparent power, unbalanced apparent power, a positive-sequence power factor, a degree of unbalance, apparent power of a harmonic wave, voltage distortion power, current distortion power, positive-sequence active power of a fundamental wave, positive-sequence reactive power of a fundamental wave, negative-sequence active power of a fundamental wave, negative-sequence reactive power of a fundamental wave, zero-sequence active power of a fundamental wave, zero-sequence reactive power of a fundamental wave, active power of a harmonic wave, harmonic distortion power and a degree of harmonic pollution. The calculation of the power parameter may also include calculation of other power parameters.

It should be noted that the method for power analysis provided by the embodiment of the present disclosure supports measurement of power parameters under multiple wiring conditions, such as single-phase two-wire, single-phase three-wire, three-phase three-wire, three-phase four-wire.

Based on the method for power analysis disclosed in the first embodiment of the present disclosure, sampling modes may be different. Preferably, the wide-band sampling performed on the voltage signal and/or the current signal is a synchronous sampling, and that the fundamental-wave decomposition is performed on the data of the second channel to obtain the fundamental-wave component includes that a Fourier transform is performed on the data of the second channel to obtain the fundamental-wave component.

Preferably, the wide-band sampling performed on the voltage signal and/or the current signal is an asynchronous sampling, and that the fundamental-wave decomposition is performed on the data of the second channel to obtain the fundamental-wave component includes that a Fourier transform is performed on the data of the second channel to obtain the fundamental-wave component.

Preferably, the wide-band sampling performed on the voltage signal and/or the current signal is an asynchronous sampling, and that the fundamental-wave decomposition is performed on the data of the second channel to obtain the fundamental-wave component includes that a wavelet transform is performed on the data of the second channel to obtain the fundamental-wave component.

According to the method for power analysis disclosed in the foregoing embodiment of the present disclosure, the embodiment of the present disclosure performs the wide-band sampling on the voltage signal and/or the current signal to obtain the voltage sampling data and/or the current sampling data, divides the voltage sampling data and/or the current sampling data into the data of two channels for transmission, calculates during the transmission, the normal power parameter for the data of the first channel to obtain the normal power parameter calculation result, performs during the transmission, the fundamental-wave decomposition on the data of the second channel to obtain the fundamental-wave component, and calculates based on the normal power parameter calculation result and the fundamental-wave component, the power parameter under the non-sinusoidal unbalanced condition to obtain the non-sinusoidal unbalanced power parameter calculation result. It can be seen that the embodiment of the disclosure can accurately measure the power parameter under the non-sinusoidal unbalanced condition, and the measurement result can truly reflect the condition of the power system. In addition, in the embodiment of the present disclosure, the wide-band sampling is performed on the voltage signal and/or the current signal, and the power parameter under the non-sinusoidal unbalanced condition is calculated according to the IEEE std 1459 standard. Therefore, it can be seen that the embodiment of the present disclosure not only supports power parameter calculation for power frequency signals with a fundamental-wave frequency of 50 Hz and 60 Hz, but also supports power parameter calculation for a wide-band non-sinusoidal signal with a fundamental-wave frequency ranging from 0.1 Hz to 5 kHz.

Further, the embodiment of the present disclosure can implement the fundamental-wave decomposition by combining the synchronous sampling and the Fourier transform, or by combining the asynchronous sampling and the Fourier transform, or by combining the asynchronous sampling and the wavelet transform. Thereby, it is further ensured that power parameters can be measured under the non-sinusoidal unbalanced condition by using the fundamental-wave component and the normal power parameter calculation result.

### Second Embodiment

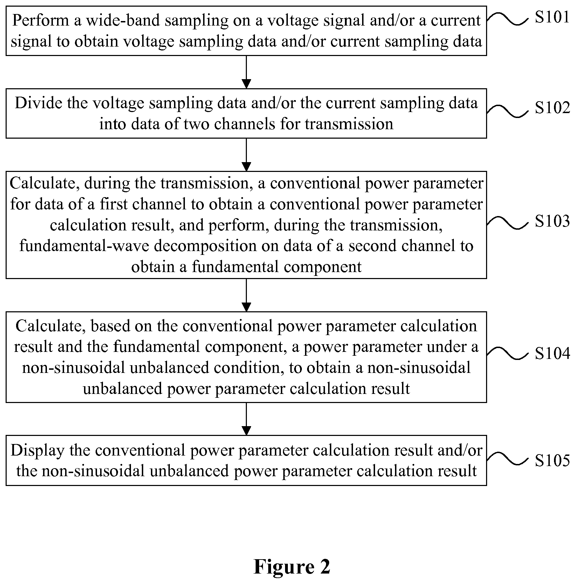

Based on the method for power analysis according to the first embodiment of the present disclosure, a method for power analysis is provided according to a second embodiment as shown in Figure 2. Based on the steps S101 to S104 as shown in Figure 1, the method further includes a step S105.

In step S105, the normal power parameter calculation result and/or the non-sinusoidal unbalanced power parameter calculation result are displayed.

It should be noted that, according to requirements, the normal power parameter calculation result may be separately displayed, or the non-sinusoidal unbalanced power parameter calculation result may be separately displayed, or the normal power parameter calculation result and the non-sinusoidal unbalanced power parameter calculation result may be simultaneously displayed for comparison.

According to the method for power analysis disclosed in the foregoing embodiment of the present disclosure, the embodiment of the present disclosure performs the wide-band sampling on the voltage signal and/or the current signal to obtain the voltage sampling data and/or the current sampling data, divides the voltage sampling data and/or the current sampling data into the data of two channels for transmission, calculates during the transmission, the normal power parameter for the data of the first channel to obtain the normal power parameter calculation result, performs during the transmission, the fundamental-wave decomposition on the data of the second channel to obtain the fundamental-wave component, and calculates based on the normal power parameter calculation result and the fundamental-wave component, the power parameter under the non-sinusoidal unbalanced condition to obtain the non-sinusoidal unbalanced power parameter calculation result. It can be seen that the embodiment of the disclosure can accurately measure the power parameter under the non-sinusoidal unbalanced condition, and the measurement result can truly reflect the condition of the power system. In addition, in the embodiment of the present disclosure, wide-band sampling is performed on the voltage signal and/or the current signal, and the power parameter under the non-sinusoidal unbalanced condition is calculated according to the IEEE std 1459 standard. Therefore, it can be seen that the embodiment of the present disclosure not only supports power parameter calculation for power frequency signals with a fundamental-wave frequency of 50 Hz and 60 Hz, but also supports the power parameter calculation for a wide-band non-sinusoidal signal with a fundamental-wave frequency from 0.1 Hz to 5 kHz.

Further, the normal power parameter calculation result and/or the non-sinusoidal unbalanced power parameter calculation result are displayed. Thereby, it may be achieved that the normal power parameter calculation result or the non-sinusoidal unbalanced power parameter calculation result is separately displayed, and it may be achieved that the power parameter calculation result and the non-sinusoidal unbalanced power parameter calculation result are displayed for comparison.

### Third Embodiment

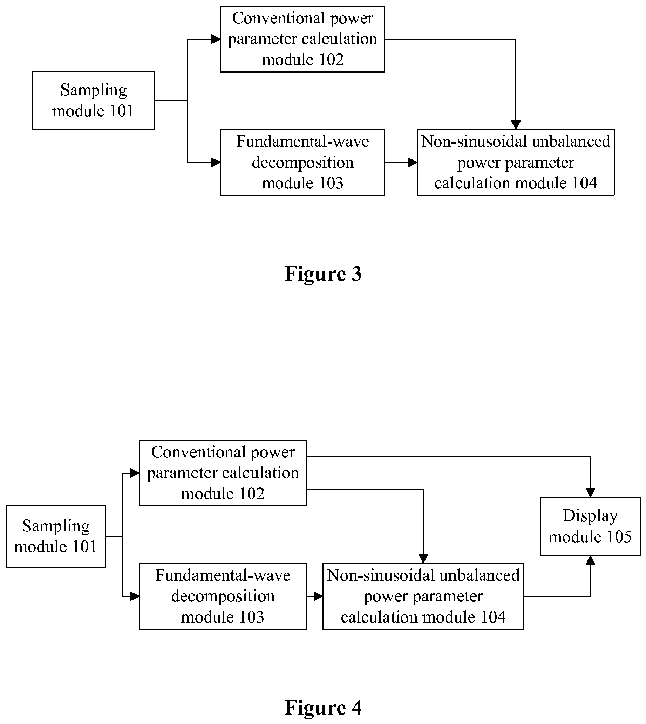

An apparatus for power analysis is provided according to a third embodiment of the present disclosure. As shown in Figure 3, the apparatus for power analysis according to the third embodiment of the present disclosure includes a sampling module 101, a normal power parameter calculation module 102, a fundamental-wave decomposition module 103, and a non-sinusoidal unbalanced power parameter calculation module 104.

An output terminal of the sampling module 101 is respectively connected to an input terminal of the normal power parameter calculation module 102 and an input terminal of the fundamental-wave decomposition module 103. The sampling module 101 is configured to perform a wide-band signal sampling on a voltage signal and/or a current signal, and divide voltage sampling data and/or current sampling data that are obtained into data of two channels. The data of a first channel is sent to the normal power parameter calculation module 102, and the data of a second channel is sent to the fundamental-wave decomposition module 103.

It should be noted that the wide-band sampling of the voltage signal and/or the current signal enables sampling of a wide-band non-sinusoidal signal having a fundamental-wave frequency ranging from 0.1 Hz to 5 kHz.

It should be noted that, in a case that the sampling module performs the wide-band sampling only on the voltage signal, the voltage sampling data is obtained, and the voltage sampling data is divided into the data of two channels, where data of the first channel and data of the second channel are both voltage sampling data.

In a case that the sampling module performs the wide-band sampling only on the current signal, the current sampling data is obtained, and the current sampling data is divided into the data of two channels, where data of the first channel and data of the second channel are both current sampling data.

In a case that the sampling module simultaneously performs wide-band sampling on the voltage signal and the current signal, the voltage sampling data and the current sampling data are obtained, and the voltage sampling data and the current sampling data are divided into the data of two channels, where each of data of the first channel and data of the second channel includes voltage sampling data and current sampling data.

The input terminal of the normal power parameter calculation module 102 is connected to the output terminal of the sampling module 101. An output terminal of the normal power parameter calculation module 102 is connected to a first input terminal of the non-sinusoidal unbalanced power parameter calculation module 104. The normal power parameter calculation module 102 is configured to calculate a normal power parameter for the data of the first channel to obtain a normal power parameter calculation result, and send the normal power parameter calculation result to the non-sinusoidal unbalanced power parameter calculation module 104.

The input terminal of the fundamental-wave decomposition module 103 is connected to the output terminal of the sampling module 101. An output terminal of the fundamental-wave decomposition module 103 is connected to a second input terminal of the non-sinusoidal unbalanced power parameter calculation module 104. The fundamental-wave decomposition module 103 is configured to perform fundamental-wave decomposition on the data of the second channel to obtain a fundamental-wave component, and send the fundamental-wave component to the non-sinusoidal unbalanced power parameter calculation module 104.

The first input terminal of the non-sinusoidal unbalanced power parameter calculation module 104 is connected to the output terminal of the normal power parameter calculation module 102. The second input terminal of the non-sinusoidal unbalanced power parameter calculation module 104 is connected to the output terminal of the fundamental-wave decomposition module 103. The non-sinusoidal unbalanced power parameter calculation module 104 is configured to calculate a power parameter under a non-sinusoidal unbalanced condition, based on the fundamental-wave component calculation result and the normal power parameter, to obtain a non-sinusoidal unbalanced power parameter calculation result.

The power parameter under the non-sinusoidal unbalanced condition is calculated according to IEEE std 1459, which is a calculation standard established by the Institute of Electrical and Electronics Engineers for power parameters under the non-sinusoidal unbalanced condition.

It should be noted that calculation of the normal power parameter includes, but is not limited to, calculation of an effective value of voltage, an effective value of current, active power, apparent power, reactive power, and a power factor.

Similarly, calculation of the power parameter under the non-sinusoidal unbalanced condition includes, but is not limited to, calculation of a voltage of a fundamental wave, a current of a fundamental wave, a voltage of a non-fundamental wave, a current of a non-fundamental wave, equivalent apparent power, non-active power, equivalent power of a fundamental wave, equivalent apparent power of a non-fundamental wave, basic sinusoidal apparent power, unbalanced apparent power, a positive-sequence power factor, a degree of unbalance, apparent power of a harmonic wave, voltage distortion power, current distortion power, positive-sequence active power of a fundamental wave, positive-sequence reactive power of a fundamental wave, negative-sequence active power of a fundamental wave, negative-sequence reactive power of a fundamental wave, zero-sequence active power of a fundamental wave, zero-sequence reactive power of a fundamental wave, active power of a harmonic wave, harmonic distortion power and a degree of harmonic pollution. The calculation of the power parameter may also include calculation of other power parameters.

It should be further noted that the method for power analysis according to the embodiment of the present disclosure supports the measurement of power parameters under multiple wiring conditions, such as single-phase two-wire, single-phase three-wire, three-phase three-wire, and three-phase four-wire.

Based on the apparatus for power analysis according to the third embodiment of the present disclosure, sampling manners may be different. Preferably, the fundamental-wave decomposition module 103 is configured to perform a Fourier transform on the data of the second channel to obtain the fundamental-wave component, in a case that the wide-band sampling performed on the voltage signal and/or the current signal by the sampling module 101 is a synchronous sampling.

Preferably, the fundamental-wave decomposition module 103 is configured to perform a Fourier transform on the data of the second channel to obtain the fundamental-wave component, in a case that the wide-band sampling performed on the voltage signal and/or the current signal by the sampling module 101 is an asynchronous sampling.

Preferably, the fundamental-wave decomposition module 103 is configured to perform a wavelet transform on the data of the second channel to obtain the fundamental-wave component, in a case that the wide-band sampling performed on the voltage signal and/or the current signal by the sampling module 101 is an asynchronous sampling.

The apparatus for power analysis according to the embodiment of the present disclosure includes the sampling module, the normal power parameter calculation module, the fundamental-wave decomposition module, and the non-sinusoidal unbalanced power parameter calculation module. The output terminal of the sampling module is respectively connected to the input terminal of the normal power parameter calculation module and the input terminal of the fundamental-wave decomposition module. The sampling module is configured to perform the wide-band sampling on the voltage signal and/or current signal, and divide the obtained voltage sampling data and/or current sampling current data into the data of two channels, where the data of the first channel is sent to the normal power parameter calculation module, and the data of the second channel is sent to the fundamental-wave decomposition module. The input terminal of the normal power parameter calculation module is connected to the output terminal of the sampling module, and the output terminal of the normal power parameter calculation module is connected to the first input terminal of the non-sinusoidal unbalanced power parameter calculation module. The normal power parameter calculation module is configured to calculate the normal power parameter for the data of the first channel to obtain the normal power parameter calculation result, and send the normal power parameter calculation result to the non-sinusoidal unbalanced power parameter calculation module. The input terminal of the fundamental-wave decomposition module is connected to the output terminal of the sampling module, and the output terminal of the fundamental-wave decomposition module is connected to the second input terminal of the non-sinusoidal unbalanced power parameter calculation module. The fundamental-wave decomposition module is configured to perform fundamental-wave decomposition on the data of the second data to obtain the fundamental-wave component, and send the fundamental-wave component to the non-sinusoidal unbalanced power parameter calculation module. The first input terminal of the non-sinusoidal unbalanced power parameter calculation module is connected to the output terminal of the normal power parameter calculation module, and the second input terminal of the non-sinusoidal unbalanced power parameter calculation module is connected to the output terminal of the fundamental-wave decomposition module. The non-sinusoidal unbalanced power parameter calculation module is configured to calculate the power parameter under the non-sinusoidal unbalanced condition, based on the fundamental-wave component and the normal power parameter calculation result, so as to obtain the non-sinusoidal unbalanced power parameter calculation result. It can be seen that the embodiment of the disclosure can accurately measure the power parameter under the non-sinusoidal unbalanced condition, and the measurement result can truly reflect the condition of the power system. In addition, in the embodiment of the present disclosure, the wide-band sampling is performed on the voltage signal and/or the current signal, and the power parameter under the non-sinusoidal unbalanced condition is calculated according to the IEEE std 1459 standard. It can be seen that the embodiment of the present disclosure not only supports power parameter calculation of power frequency signals with a fundamental-wave frequency of 50 Hz and 60 Hz, and also supports power parameter calculation of a wide-band non-sinusoidal signal with a fundamental-wave frequency from 0.1 Hz to 5 kHz.

Further, the embodiment of the present disclosure can implement the fundamental-wave decomposition by combining the synchronous sampling and the Fourier transform, or by combining the asynchronous sampling and the Fourier transform, or by combining the asynchronous sampling and the wavelet transform. It is further ensured that the power parameters can be measured under the non-sinusoidal unbalanced condition by using the fundamental-wave component and the normal power parameter calculation result.

### Fourth Embodiment

Based on the apparatus for power analysis according to the third embodiment of the present disclosure, an apparatus for power analysis is provided according to a fourth embodiment of the present disclosure, as shown in Figure 4. On the basis of the apparatus for power analysis according to the third embodiment of the present disclosure, the apparatus further includes a display module 105.

The display module 105 is connected to the output terminal of the normal power parameter calculation module 102 and an output terminal of the non-sinusoidal unbalanced power parameter calculation module 104. The display module 105 is configured to display the normal power parameter calculation result and/or the non-sinusoidal unbalanced power parameter calculation result.

Preferably, the display module includes a liquid crystal display.

Preferably, the display module includes a multi-screen display.

It should be noted that, according to requirements, the normal power parameter calculation result may be separately displayed, or the non-sinusoidal unbalanced power parameter calculation result may be separately displayed, or the normal power parameter calculation result and the non-sinusoidal unbalanced power parameter calculation result may be simultaneously displayed for comparison.

The apparatus for power analysis according to the embodiment of the present disclosure can realize accurate measurement of the power parameter under the non-sinusoidal unbalanced condition. The measurement result truly reflects the condition of the power system.

Further, the apparatus further includes the display module. The display module is connected to the output terminal of the normal power parameter calculation module and the output terminal of the non-sinusoidal unbalanced power parameter calculation module. The display module is configured to display a normal power parameter calculation result and/or a non-sinusoidal unbalanced power parameter calculation result. It can be seen that the display of the normal power parameter calculation result or the non-sinusoidal unbalanced power parameter calculation result is achieved, and the comparative display of the normal power parameter calculation result or the non-sinusoidal unbalanced power parameter calculation result may also be achieved.

It should be noted that the embodiments of the present disclosure are described in a progressive manner, and each embodiment places emphasis on the difference from other embodiments. Therefore, one embodiment can refer to other embodiments for the same or similar parts. Since the apparatus disclosed in the embodiments corresponds to the method disclosed in the embodiments, the description of the apparatus is simple, and reference may be made to the relevant part of the method.

It should be noted that, the relationship terms such as "first", "second" and the like are only used herein to distinguish one entity or operation from another, rather than to necessitate or imply that an actual relationship or order exists between the entities or operations. Furthermore, the terms such as "include", "comprise" or any other variants thereof means to be non-exclusive. Therefore, a process, a method, an article or a device including a series of elements include not only the disclosed elements but also other elements that are not clearly enumerated, or further include inherent elements of the process, the method, the article or the device. Unless expressly limited, the statement "including a... " does not exclude the case that other similar elements may exist in the process, the method, the article or the device other than enumerated elements.

According to the description of the disclosed embodiments, those skilled in the art can implement or use the present disclosure. Various modifications made to these embodiments may be obvious to those skilled in the art, and the general principle defined herein may be implemented in other embodiments without departing from the spirit or scope of the present disclosure. Therefore, the present disclosure is not limited to the embodiments described herein but confirms to a widest scope in accordance with principles and novel features disclosed in the present disclosure.

## Claims

1. A method for power analysis method, comprising:
performing a wide-band sampling on a voltage signal and/or a current signal to obtain voltage sampling data and/or current sampling data;
dividing the voltage sampling data and/or the current sampling data into data of two channels for transmission;
calculating, during the transmission, a normal power parameter for data of a first channel to obtain a normal power parameter calculation result, and performing, during the transmission, fundamental-wave decomposition on data of a second channel to obtain a fundamental-wave component; and
calculating, based on the normal power parameter calculation result and the fundamental-wave component, a power parameter under a non-sinusoidal unbalanced condition, to obtain a non-sinusoidal unbalanced power parameter calculation result;
wherein the power parameter under the non-sinusoidal unbalanced condition is calculated according to a calculation standard IEEE std 1459 that is established by the Institute of Electrical and Electronics Engineers for power parameters under the non-sinusoidal unbalanced condition.

2. The method according to claim 1, further comprising:
displaying the normal power parameter calculation result and/or the non-sinusoidal unbalanced power parameter calculation result.

3. The method according to claim 1, wherein the wide-band sampling performed on the voltage signal and/or the current signal is a synchronous sampling, and performing fundamental-wave decomposition on the data of the second channel to obtain the fundamental-wave component comprises:
performing a Fourier transform on the data of the second channel to obtain the fundamental-wave component.

4. The method according to claim 1, wherein the wide-band sampling performed on the voltage signal and/or the current signal is an asynchronous sampling, and performing fundamental-wave decomposition on the data of the second channel to obtain the fundamental-wave component comprises:
performing a Fourier transform on the data of the second channel to obtain the fundamental-wave component.

5. The method according to claim 1, wherein the wide-band sampling performed on the voltage signal and/or the current signal is an asynchronous sampling, and performing fundamental-wave decomposition on the data of the second channel to obtain the fundamental-wave component comprises:
performing a wavelet transform on the data of the second channel to obtain the fundamental-wave component.

6. An apparatus for power analysis, comprising a sampling module, a normal power parameter calculation module, a fundamental-wave decomposition module, and a non-sinusoidal unbalanced power parameter calculation module; wherein:
an output terminal of the sampling module is respectively connected to an input terminal of the normal power parameter calculation module and an input terminal of the fundamental-wave decomposition module, and the sampling module is configured to perform a wide-band sampling on a voltage signal and/or a current signal, and divide voltage sampling data and/or the current sampling data that are obtained into data of two channels, wherein data of a first channel is sent to the normal power parameter calculation module, and data of a second channel is sent to the fundamental-wave decomposition module;
the input terminal of the normal power parameter calculation module is connected to the output terminal of the sampling module, an output terminal of the normal power parameter calculation module is connected to a first input terminal of the non-sinusoidal unbalanced power parameter calculation module, and the normal power parameter calculation module is configured to calculate a normal power parameter for the data of the first channel to obtain a normal power parameter calculation result, and send the normal power parameter calculation result to the non-sinusoidal unbalanced power parameter calculation module;
the input terminal of the fundamental-wave decomposition module is connected to the output terminal of the sampling module, an output terminal of the fundamental-wave decomposition module is connected to a second input terminal of the non-sinusoidal unbalanced power parameter calculation module, and the fundamental-wave decomposition module is configured to perform fundamental-wave decomposition on the data of the second channel to obtain a fundamental-wave component, and send the fundamental-wave component to the non-sinusoidal unbalanced power parameter calculation module;
the first input terminal of the non-sinusoidal unbalanced power parameter calculation module is connected to the output terminal of the normal power parameter calculation module, the second input terminal of the non-sinusoidal unbalanced power parameter calculation module is connected to the output terminal of the fundamental-wave decomposition module, and the non-sinusoidal unbalanced power parameter calculation module is configured to calculate, based on the fundamental-wave component and the normal power parameter calculation result, a power parameter under a non-sinusoidal unbalanced condition, to obtain a non-sinusoidal unbalanced power parameter calculation result; and
the power parameter under the non-sinusoidal unbalanced condition is calculated according to a calculation standard IEEE std 1459 that is established by the Institute of Electrical and Electronics Engineers for power parameters under the non-sinusoidal unbalanced condition.

7. The apparatus according to claim 6, further comprising a display module, wherein:
the display module is connected to the output terminal of the normal power parameter calculation module and an output terminal of the non-sinusoidal unbalanced power parameter calculation module, and is configured to display the normal power parameter calculation result and/or the non-sinusoidal unbalanced power parameter calculation result.

8. The apparatus according to claim 6, wherein the wide-band sampling performed on the voltage signal and/or the current signal by the sampling module is a synchronous sampling, and the fundamental-wave decomposition module is configured to perform a Fourier transform on the data of the second channel to obtain the fundamental-wave component.

9. The apparatus according to claim 6, wherein the wide-band sampling performed on the voltage signal and/or the current signal by the sampling module is an asynchronous sampling, and the fundamental-wave decomposition module is configured to perform a Fourier transform on the data of the second channel to obtain the fundamental-wave component.

10. The apparatus according to claim 6, wherein the wide-band sampling performed on the voltage signal and/or the current signal by the sampling module is an asynchronous sampling, and the fundamental-wave decomposition module is configured to perform a wavelet transform on the data of the second channel to obtain the fundamental-wave component.
